# EUROPÄISCHE PATENTANMELDUNG

(11) **EP 2 999 320 A1**
(43) Veröffentlichungstag der Anmeldung: **23.03.2016**
(21) Anmeldenummer: 14185527.0
(22) Anmeldetag: 19.09.2014
(51) Int. Cl.: H05K 7/20

(54) **Vorrichtung zur Übertragung von Wärme**

(71) Anmelder: Pentair Technical Solutions GmbH, 75334 Straubenhardt (DE)
(72) Erfinder: Joist, Michael, 76571 Gaggenau (DE)
(74) Vertreter: Durm & Partner

(57) **Zusammenfassung**

Eine Vorrichtung zur Übertragung von Wärme umfasst zwei massive Wärmeleitkörper (1, 2), die mit variablem Abstand vertikal übereinander angeordnet sind. Zwischen den Wärmeleitkörpern (1, 2) sitzt eines oder mehrere Spreizelemente (8, 9), welche jeweils zwei horizontal bewegbare Keile (10a, 10b, 12a, 12b) mit voneinander weg weisenden Keilspitzen umfasst sowie eine Feder (11, 12), welche die Keile auseinanderdrückt. Die Wärmeleitkörper (1, 2) haben korrespondierende Gleitflächen (6a, 6b, 7a, 7b), welche parallel zu den Keilflächen (14) verlaufen. Eine Bewegung der Keile (10a, 10b, 12a, 12b) in horizontaler Richtung wird in eine vertikale Bewegung der Wärmeleitkörper (1, 2) umgesetzt, wodurch sich die Höhe der gesamten Vorrichtung automatisch an die Einbausituation anpasst.

## Beschreibung

Die Erfindung betrifft eine Vorrichtung zur Übertragung von Wärme zwischen einer Wärmequelle und einer Wärmesenke durch Wärmeleitung. Ein solcher Wärmeübertrager wird insbesondere in der Industrieelektronik eingesetzt, um die Verlustleistung elektronischer Komponenten abzuleiten.

Elektronische Komponenten, wie zum Beispiel Mikroprozessoren, sitzen auf Leiterplatten, die in der Regel in ein Gehäuse eingebaut werden. Bei einem so genannten Singleboard Computer sind alle wesentlichen elektronischen Komponenten des Computers auf einer einzigen Leiterplatte, dem so genannten Motherboard angeordnet. Es besteht eine Tendenz zu immer kleineren Formaten, wie zum Beispiel dem standardisierten Mini-ITX mit einer Abmessung von 170 x 170 mm, in dessen Mitte ein leistungsfähiger Prozessor sitzt.

Moderne Mehrkern-Prozessoren mit hoher Taktrate weisen eine so hohe thermische Verlustleistung auf, dass sie für einen sicheren Betrieb einer gezielten Kühlung bedürfen. Dies geschieht in der Regel mittels eines Kühlkörpers, der auf die plane Oberfläche des Prozessors aufgesetzt wird und eine Vielzahl von Kühlrippen aufweist, damit die Abwärme von einer großen Fläche durch Konvektion an die umgebende Luft abgeführt werden kann.

Für viele Anwendungszwecke müssen die elektronischen Komponenten eines Geräts in einem Gehäuse eingeschlossen werden, um es gegen Staub, Feuchtigkeit sowie Störstrahlungen zu schützen. Um dennoch die im Innern des Geräts erzeugte Abwärme nach außen abzuführen, kann das Gehäuse Lufteintritts- und Luftaustrittsöffnungen haben und/oder mit einem elektrischen Lüfter ausgestattet sein, welcher Kühlluft durch das Gehäuse hindurch bläst. In vielen Bereichen ist allerdings ein vollständig geschlossenes Gehäuse gefordert, um erhöhte Anforderungen an Staub- und Feuchtigkeitsschutz zu erfüllen.

Gehäuse für elektronische Geräte, insbesondere Industrie-Computer, mit höherer IP-Schutzklasse sind rundum dicht abgeschlossen, so dass keine Kühlluft mehr durch das Gehäuse hindurch geleitet werden kann. Stattdessen besitzen solche geschlossenen Gehäuse an ihren Außenseiten große Kühlkörper, die zum Beispiel als extrudierte Profilkörper ausgeführt sind. Es stellt sich hier das Problem, die elektronischen Komponenten im Innern des Gehäuses, also insbesondere den Prozessor oder die Prozessoren thermisch mit den Kühlkörpern an der Außenseite des Gehäuses zu verbinden, so dass die Verlustwärme durch Wärmeleitung zu den Kühlkörpern transportiert und dort durch Konvektion und/oder Wärmestrahlung an die Umgebung abgegeben werden kann.

Bekannt sind massive rechteckige Metallklötze, die mit der Unterseite auf den Prozessor aufgesetzt werden und mit ihrer Oberseite an der Innenseite einer Gehäusewand anliegen, um die Wärme vom Prozessor an die Gehäusewand zu übertragen. Ein Problem hierbei sind die relativ großen Toleranzen der elektronischen und mechanischen Komponenten, insbesondere also der Prozessoren und der Bauteile des Schutzgehäuses. Schon die Bauhöhe eines marktüblichen Prozessors hat eine typische Toleranz von bis zu 1 mm. An der Wärmeübergangsstelle wird deshalb oft ein elastisches oder pastöses Material verwendet, das sich durch gute Wärmeleitfähigkeit auszeichnet. Die Dicke der Schicht von Wärmeleitpaste muss allerdings möglichst klein gehalten werden, denn die Wärmeleitfähigkeit auch der besten verfügbaren Produkte liegt um Größenordnungen niedriger als die Wärmeleitfähigkeit von Metall zum Beispiel Aluminium. Wird auch das andere Ende des Metallklotzes mithilfe von Wärmeleitpasten in thermischen Kontakt mit der Gehäusewand gebracht, wird der Wärmewiderstand noch größer.

Bei der Konstruktion und Produktion und Produktion von standardisierten Kleingehäusen für Industriecomputer besteht eine weitere Problematik darin, dass zwar die Abmessungen der Leiterplatte festliegen, aber offen bleiben soll, welcher Prozessortyp verwendet wird. Unterschiedlich leistungsfähige Prozessoren verschiedener Hersteller wie Intel, AMD, ARM oder VIA unterscheiden sich nicht nur durch ihre elektronischen Parameter und unterschiedliche Verlustleistungen, sondern auch hinsichtlich ihrer geometrischen Abmessungen. Für diese Prozessoren werden zwar universell einsetzbare Kühlkörper und Wärmeübertrager angeboten, das hierzu erforderliche Montagematerial muss aber die Toleranzen für die gesamte Konstruktion ausgleichen. Die Toleranzen für die Dicke des Prozessors, des Sockels, des Kühlkörpers oder Übertragers und gegebenenfalls des Gehäuses summieren sich somit auf einen Wert in der Größenordnung von 2 mm oder sogar mehr. Allein mit Wärmeleitpaste oder sogenanntem gap-filler lassen sich derart große Toleranzen nicht mehr ausgleichen, wenn noch eine effektive Kühlung gewährleistet werden soll.

Eine weitere Herausforderung in diesem Zusammenhang besteht darin, dass auch bei einem vollständig geschlossenen Gehäuse zumindest der obere Deckel abnehmbar sein soll, um gegebenenfalls an die eingeschlossene Elektronik heranzukommen. Wird nach einer Reparatur der Deckel wieder aufgesetzt, muss auch die Wärmeleitung zwischen Prozessor und Deckel wieder vollständig hergestellt werden. Wärmeleitpaste ist allerdings schlecht für eine mehrfache Verwendung geeignet.

US 2007/0030656 A1 beschreibt eine Wärmeübertragungsvorrichtung mit variabler Höhe. Die Vorrichtung umfasst zwei ineinandergreifende Körper, von denen der erste Körper Kontakt zu einem Wärme abgebenden Bauteil hat und der zweite Körper in vertikaler Richtung gegenüber dem ersten Körper verschieblich ist. Zwischen den beiden Körpern sitzt eine Feder, welche den oberen Körper nach oben gegen die Innenseite eines Deckels eines Gehäuses drückt. Der Federdruck sorgt also dafür, dass der obere Körper stets Kontakt hat zu dem Gehäusedeckel, auch wenn dessen relative Höhe zum Gehäuseboden variiert, zum Beispiel aufgrund von Toleranzen bei der Herstellung. Bei der vorbekannten Vorrichtung ist der untere Wärmeleitkörper in der Art eines Kolbens und der obere Wärmeleitkörper in der Art eines Zylinders ausgebildet, welcher in dem Kolben auf- und abgleiten kann. Dadurch ergeben sich lange vertikale Spalten zwischen den beiden Körpern, welche den Wärmefluss großflächig unterbrechen. Der Spalt bzw. das Spiel zwischen den beiden Körpern darf ein gewisses Mindestmaß nicht unterschreiten, sofern nicht die Beweglichkeit der beiden Körper gegeneinander behindert oder gar unterbunden werden soll. Es wird deshalb vorgeschlagen, auf den gegeneinander gleitenden Flächen ein Schmiermittel aufzubringen, vorzugsweise ein Schmieröl mit erhöhter Wärmeleitfähigkeit.

Angesichts der geschilderten Problematik stellt sich die Aufgabe, eine verbesserte Wärmeleitvorrichtung zu schaffen, welche einen relativ großen Toleranzbereich ausgleichen kann und sich trotzdem durch maximale Wärmeleitfähigkeit auszeichnet.

Bei der Lösung der Aufgabe wird ausgegangen von einer Vorrichtung gemäß dem Oberbegriff des Patentanspruchs 1. Gelöst wird die Aufgabe durch die kennzeichnenden Merkmale des Patentanspruchs.

Der erfindungsgemäße Wärmeübertrager hat zwei massive Wärmeleitkörper, die mit variablem Abstand vertikal übereinander angeordnet sind. Zwischen den beiden Körpern sitzt wenigstens ein Spreizelement, das zwei horizontal bewegbare Keile umfasst. Die Keilspitzen weisen in entgegengesetzte Richtungen. Zwischen den Keilen ist mindestens eine Feder angeordnet, welche die Keile entlang einer horizontalen Achse auseinander drückt. Die Wärmeleitkörper haben an ihren zueinander weisenden Seiten korrespondierende Gleitflächen, die paarweise angeordnet sind. Die Keilflächen gleiten auf den Gleitflächen der Wärmeleitkörper derart, dass eine Bewegung der Keile in horizontaler Richtung in eine vertikale Bewegung der Wärmeleitkörper umgesetzt wird. Dabei verlaufen die Keilflächen stets parallel zu den Gleitflächen.

Die Kraft der Feder, welche durch Druck auf den oberen Wärmeleitkörper kompensiert wird, sorgt dafür, dass die Keilflächen stets ohne nennenswerten Spalt an den Gleitflächen der Wärmeleitkörper anliegen. Trotzdem ist der vertikale Abstand zwischen den beiden Wärmeleitkörpern variabel, so dass sich die Höhe der Wärmeübertragungsvorrichtung automatisch an die baulichen Gegebenheiten anpasst, um zum Beispiel unterschiedlich hohe Prozessoren oder Fertigungstoleranzen des Gehäuses auszugleichen. Die Feder sorgt auch dafür, dass die Keile auf die Gleitflächen der Wärmeleitkörper gedrückt werden, so dass ein guter Wärmeübergang zwischen Keilen und Wärmeleitkörpern gewährleistet ist. Wärmeleitkörper und Keile ergänzen sich so zu einem fast vollständig massiven Körper mit minimalem Wärmewiderstand zwischen den außenliegenden Kontaktflächen.

Bevorzugt haben die Keile einen Querschnitt, bei dem die Keilflächen auf den Schenkeln eines gleichschenkligen Dreiecks liegen. Die Form der Keile ist damit symmetrisch in Bezug auf eine horizontale Achse, die quer zur Bewegungsrichtung der Wärmeleitkörper verläuft. Dadurch ergibt sich ein doppelter Hub in vertikaler Richtung als dies bei Verwendung von Keilen mit nur einer schrägen Keilfläche der Fall wäre. Grundsätzlich sind aber auch andere Querschnittsformen für die Keile denkbar, zum Beispiel die Form eines quer liegenden rechtwinkligen Dreiecks, bei dem dann eine, vorzugsweise die obere Keilfläche schräg und die andere Keilfläche parallel zur Horizontalen verläuft.

Um auf kurzem horizontalen Weg einen großen Hub in vertikaler Richtung zu erzielen, ist es zweckmäßig, die Keilflächen in einem stumpfen Winkel anzuordnen. Dies ist hier möglich, da die zu bewegenden Gewichte und damit die Reibungskräfte zwischen Keilflächen und Gleitflächen relativ gering sind. Sollte die Vorrichtung allerdings größere Abmessungen aufweisen, könnte eine Anordnung der Keilflächen in einem Winkel von weniger als 90 Grad vorteilhaft sein.

Aus der dreieckigen Form der Keile und ihrer gegenläufigen Bewegung ergibt sich, dass die Paare von Gleitflächen an den Wärmeleitkörpern jeweils in Form eines großen V bzw. umgekehrten V angeordnet sind, wobei sich der Winkel zwischen zwei aneinanderstoßenden Gleitflächen und der Winkel zwischen den Keilflächen zu 180 Grad ergänzen. Somit verlaufen die Keilflächen immer parallel zu den Gleitflächen, was wichtig ist, um einen möglichst guten Wärmekontakt zwischen den Keilen und den Wärmeleitkörpern herzustellen. Die Umlenkung der Federkraft durch die Keile in die Vertikale sorgt dafür, dass die Keilflächen unabhängig von ihrer Stellung plan gegen die korrespondierenden Gleitflächen gepresst werden.

Die zwischen den Keilen angeordnete Feder ist vorzugsweise als Schraubenfeder ausgebildet, wobei die Federachse in einer horizontalen Ebene durch die Keilspitze liegt. Bevorzugt wird man zwei oder mehr Federn parallel nebeneinander anordnen, um ein Verkanten der Keile zu verhindern. Sind die Keile und die Keilflächen symmetrisch zu beiden Seiten derselben horizontalen Ebene angeordnet, ergibt sich eine insgesamt symmetrische Anordnung, die Vorteile hinsichtlich der Kinematik bietet, insbesondere zu einer automatischen Zentrierung der Keile in dem durch je eine Gleitfläche der beiden Wärmeleitkörper gemeinsam gebildeten Lager bewirken. Ein Verkanten der Wärmeleitkörper wird dadurch verhindert.

Die Wärmeleitkörper können durch eine Führung so miteinander verbunden sein, dass sie im Wesentlichen nur in vertikaler Richtung gegeneinander beweglich sind, seitlich jedoch nicht ausweichen können. Diese Vertikalführung kann vorteilhaft einen Anschlag haben, der die maximale gegenseitige Verschiebung der Wärmeleitkörper begrenzt. Auch bei vollständig entspannter Feder, also maximal möglichem Abstand der Wärmeleitkörper voneinander, wird dadurch ein Auseinanderfallen der Vorrichtung verhindert, die Montage wird vereinfacht.

Anstelle einer einzigen Spreizvorrichtung mit zwei Keilen und einer Feder können auch zwei gleich ausgebildete Spreizelemente horizontal nebeneinander angeordnet sein. In diesem Falle haben die beiden Wärmeleitkörper jeweils zwei Paare von V-förmig angeordneten Gleitflächen, auf denen die Keile je eines der beiden Spreizelemente gleiten. Insbesondere für etwas breitere Wärmeübertragungsvorrichtungen ist die Anordnung von zwei gleichen Spreizelementen vorteilhaft, da damit automatisch eine konstante Verspannung der beiden Wärmeleitkörper zueinander gewährleistet ist. Für noch breitere Vorrichtungen ist es auch denkbar, mehr als zwei Spreizelemente horizontal nebeneinander anzuordnen.

Die Wärmeleitkörper werden bevorzugt einstückig als Strangpressprofil hergestellt. Das Material ist vorzugsweise ein Metall mit sehr guter Wärmeleitfähigkeit, insbesondere Aluminium oder Kupfer. Auch die Keile können einstückig als Strangpressprofil aus demselben Material hergestellt werden.

Besonders vorteilhaft ist es, wenn beide Wärmeleitkörper aus dem gleichen Strangpressprofil hergestellt sind. Der obere Wärmeleitkörper unterscheidet sich dann von dem unteren Wärmeleitkörper allein dadurch, dass er um 180 Grad gedreht angeordnet ist. Da auch die Keile gleich ausgebildet sind, kann die gesamte Vorrichtung im Wesentlichen aus nur drei verschiedenen Teilen zusammengesetzt werden, nämlich aus zwei gleichen Wärmeleitkörpern, wenigstens zwei gleichen Keilen und einer Feder oder mehreren gleichen Federn. Die Vertikalführung für die Wärmeleitkörper mitsamt Anschlag kann dabei durch einstückig an die Wärmeleitkörper angeformte Stege ausgebildet werden, so dass auch hierfür keine weiteren Teile hergestellt werden müssen.

Wenn hier von "horizontal" und "vertikal" gesprochen wird, so geschieht dies zur Bestimmung der Anordnung und Bewegungsrichtungen der einzelnen Bauelemente der Vorrichtung relativ zueinander, und nicht etwa zur Definition der absoluten Winkellage im Raum. Grundsätzlich ist es nämlich möglich, die erfindungsgemäße Wärmeübertragungsvorrichtung beliebig im Raum anzuordnen, also beispielsweise auch zwischen zwei vertikal oder schräg im Raum stehenden Flächen zweier Körper, zwischen denen Wärme übertragen werden soll. Prozessoren von Computern werden allerdings in der Regel so in ein Gehäuse eingebaut, dass ihre Oberseite, von der die Wärme abgeführt werden muss, tatsächlich ungefähr horizontal im Raum ausgerichtet ist, und dass insoweit die beiden Wärmeleitkörper der erfindungsgemäßen Vorrichtung auch real ungefähr vertikal übereinander angeordnet sind. Schutz beansprucht wird jedenfalls auch für Wärmeübertragungsvorrichtungen, bei denen zum Beispiel die Wärmeleitkörper entlang einer horizontalen Achse einander gegenüberstehen und dementsprechend die Keile des mindestens einen Spreizelements entlang einer vertikalen Achse - und damit rechtwinklig bzw. quer zur Bewegungsrichtung der Wärmeleitkörper - bewegbar sind, so dass eine Bewegung der Keile in vertikaler Richtung in eine horizontale Bewegung der Wärmeleitkörper umgesetzt wird.

Zwei Ausführungsbeispiele der Erfindung werden nun anhand der beigefügten Zeichnungen im Detail erläutert. Es zeigen:
- Figur 1a: eine erste Vorrichtung zur Übertragung von Wärme, in isometrischer Darstellung;
- Figur 1b: die Vorrichtung von Figur 1a, in Seitenansicht;
- Figur 2a: das Profil der Wärmeleitkörper der Vorrichtung von Figur 1a;
- Figur 2b: die beiden Wärmeleitkörper von Figur 1a, zusammengesetzt;
- Figur 3: die Vorrichtung von Figur 1a, in zusammengedrücktem bzw. auseinandergeschobenem Zustand;
- Figur 4: eine zweite alternative Vorrichtung zur Übertragung von Wärme, in zusammengedrücktem bzw. auseinandergeschobenem Zustand, jeweils in Seitenansicht;
- Figur 5: eine Modifikation der Vorrichtung von Figur 4;
- Figur 6a, 6b, 6c: den Einbau einer Wärmeübertragungsvorrichtung gemäß Figur 1a in einem Gehäuse, perspektivisch;
- Figur 7: das Gehäuse mit eingebauter Wärmeübertragungsvorrichtung gemäß Figur 6a, in einem Vertikalschnitt.

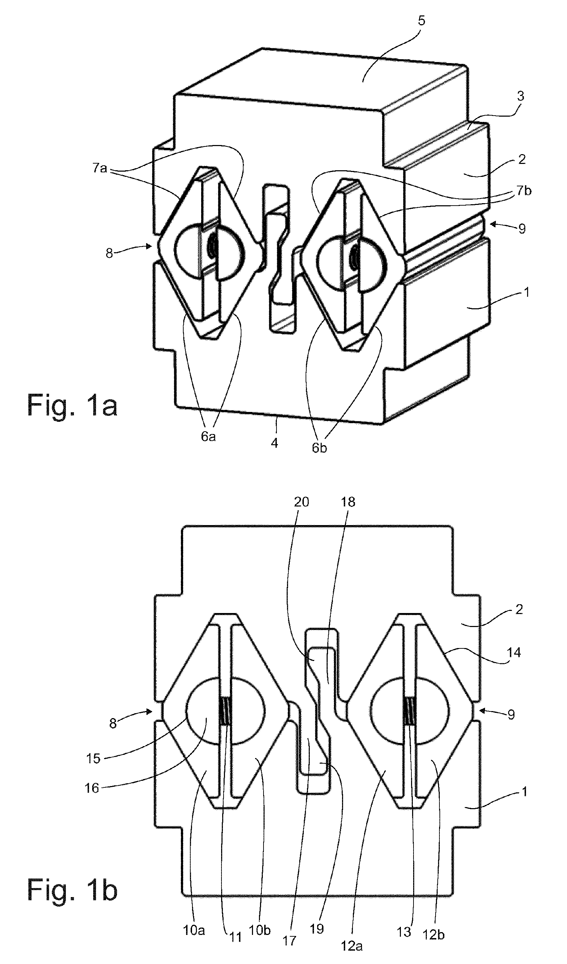

Figur 1a zeigt einen Wärmeübertrager mit einem ersten Wärmeleitkörper 1 und einem zweiten, mit Abstand vertikal darüber angeordneten Wärmeleitkörper 2. Die beiden Wärmeleitkörper 1, 2 haben im Wesentlichen die Form eines rechteckigen Quaders, wobei die schmalen Stirnseiten eine Abstufung 3 aufweisen, so dass die Breite der Wärmeleitkörper 1, 2 im Bereich ihrer gegenüberliegenden Enden etwas reduziert ist. Die Unterseite des unteren Wärmeleitkörpers 1 bildet eine erste ebene Kontaktfläche 4, die Oberseite des oberen Wärmeleitkörpers 2 eine zweite ebene Kontaktfläche 5. Diese Kontaktflächen 4, 5 dienen zur Herstellung eines flächigen Kontakts zu einem (nicht dargestellten) Bauteil, von dem Wärme abgeführt werden soll, bzw. zu einem Bauelement, wie zum Beispiel einen Gehäusedeckel, das Wärme aufnehmen kann. Der Wärmegradient entlang der vertikalen Achse des Wärmeübertragers verursacht einen Wärmefluss zwischen den beiden Kontaktflächen 4, 5 von unten nach oben oder in umgekehrter Richtung, also von oben nach unten.

An den jeweils den Kontaktflächen 4, 5 gegenüberliegenden Seiten der Wärmeleitkörper 1, 2 sind jeweils zwei Paare von Gleitflächen 6a, 6b bzw. 7a, 7b ausgebildet. Die Gleitflächen 6a, 6b des unteren Wärmeleitkörpers sind in Form eines V angeordnet; die Gleitflächen 7a, 7b des oberen Wärmeleitkörpers sind ebenfalls V-förmig angeordnet, wobei das V allerdings auf dem Kopf steht. Dies bedeutet, dass die Gleitflächen 6a, 6b, 7a, 7b auf den Schenkeln von insgesamt vier gleichschenkligen Dreiecken angeordnet sind, wobei die Spitzen von jeweils zwei Dreiecken in entgegengesetzte Richtungen weisen, so dass insgesamt zwei Rauten gebildet werden.

Zwischen den Wärmeleitkörpern 1, 2 sitzen zwei Spreizelemente 8 und 9, welche horizontal nebeneinander angeordnet sind. Das in den Figuren 1a, 1b linke Spreizelement 8 umfasst zwei Keile 10a, 10b mit voneinander wegweisenden Keilspitzen sowie eine zwischen den Keilen angeordnete Feder 11. Das gleich ausgebildete zweite Spreizelement 9 (in Figur 1b rechts) umfasst ebenfalls zwei Keile 12a, 12b mit auseinanderweisenden Spitzen und eine zwischengesetzte Feder 13. Die als Schraubenfeder ausgebildeten Federn 11, 13 drücken die zugehörigen Keile 10a, 10 bzw. 12a, 12b in horizontaler Richtung auseinander. Dabei gleiten die Keilflächen 14 auf den jeweils zugeordneten Gleitflächen 6a, 6b des unteren Wärmeleitkörpers 1 bzw. auf den Gleitflächen 7a, 7b des oberen Wärmeleitkörpers 2. Die Keilflächen 14 und die zugehörige Gleitflächen 6a, 6b bzw. 7a, 7b verlaufen dabei parallel, das heißt, sie liegen vollflächig und nahezu ohne Spalt aufeinander.

Wie insbesondere aus dem Schnittbild von Figur 1b ersichtlich, haben die Keile 10a, 10b, 12a, 12b an ihren den Keilspitzen gegenüberliegenden Rückseiten halbrunde Nuten 15, in denen Leisten 16 sitzen, deren Querschnitt ebenfalls halbkreisförmig ist. Die Federn 11, 13 stützen sich gegen die ebenen Oberseiten der Leisten 16 ab. Dabei können sich die Leisten 16 in den Nuten 15 etwas verdrehen und so eine nicht exakt horizontale Ausrichtung der Wärmeleitkörper 1 und 2 gegeneinander ausgleichen.

Die Wärmeleitkörper 1, 2 weisen an ihren gegeneinander weisenden Innenseiten spiegelbildlich geformte, jedoch seitlich etwas versetzt angeordnete Führungsstege 17, 18 auf, welche eine vertikale Führung für die Wärmeleitkörper 1, 2 bilden. An ihren freien Enden sind die Führungsstege 17, 18 nach außen abgewinkelt, wodurch horizontale Anschläge 19 bzw. 20 gebildet werden. Diese Anschläge 19, 20 begrenzen den Weg, den sich der obere Wärmeleitkörper 2 vom unteren Wärmeleitkörper 1 in vertikaler Richtung entfernen kann, wobei sich die Führungsstege 17, 18 parallel verschieben und damit eine rein vertikale Verschiebung der Wärmeleitkörper 1, 2 gegeneinander vorgeben.

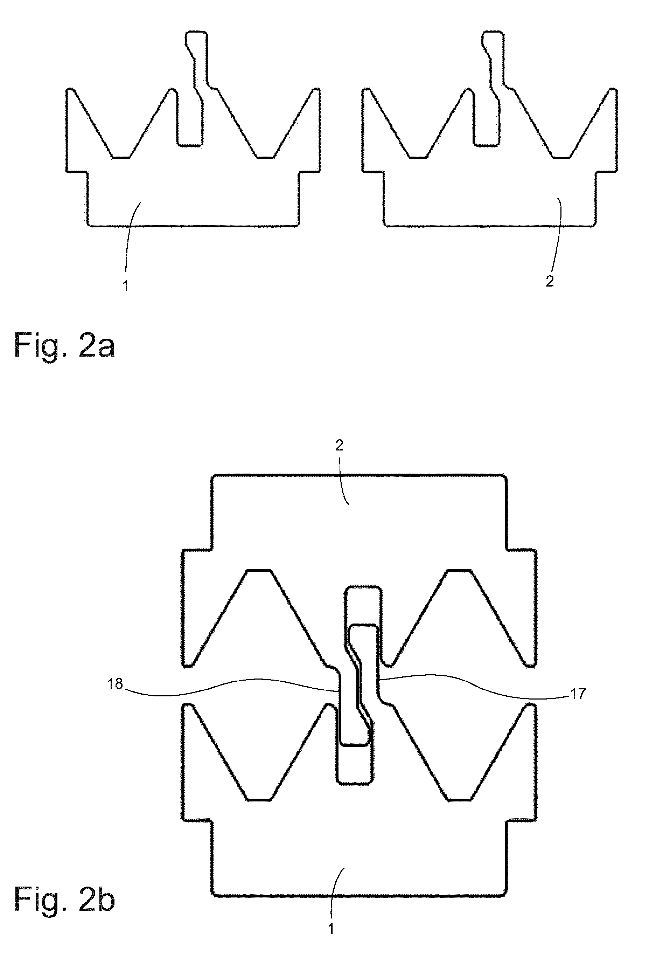

In Figur 2a sind die beiden Wärmeleitkörper 1, 2 separat dargestellt. Sie sind einstückig aus demselben Strangpressprofil hergestellt. In Figur 2a sind die beiden Wärmeleitkörper 1, 2 nebeneinander angeordnet, wohingegen Figur 2b die beiden Wärmeleitkörper 1 und 2 zusammengeschoben zeigen. Hierzu wurde der obere Wärmeleitkörper 2 um 180 Grad gedreht auf den unteren Wärmeleitkörper 1 aufgeschoben.

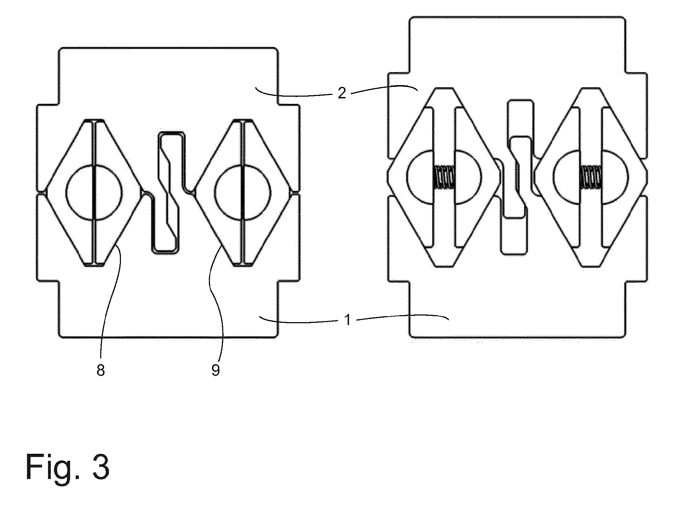

Figur 3 verdeutlicht die Funktion des zuvor beschriebenen Wärmeübertragers. In der linken Abbildung stoßen die beiden Wärmeleitkörper 1, 2 fast aneinander, haben also minimalen Abstand, so dass die gesamte Vorrichtung minimale Höhe hat. In der Abbildung rechts daneben haben sich die beiden Wärmeleitkörper 1, 2 in vertikaler Richtung maximal voneinander entfernt, so dass die Vorrichtung maximale Höhe hat. Der Unterschied zwischen minimaler und maximaler Höhe ergibt den variablen Abstand zwischen zwei (nicht dargestellten) Bauteilen, die durch die Vorrichtung zwecks Übertragung von Wärme verbunden werden können. Dabei sorgen die Federn 11, 13 dafür, dass eine Bewegung der Keile 10a, 10b bzw. 12a, 12b in horizontaler Richtung in eine vertikale Bewegung der Wärmeleitkörper 1, 2 in vertikaler Richtung gegeneinander umgesetzt wird. In der linken Abbildung von Figur 3 sind die Federn 11, 13 maximal zusammengedrückt, während sie in der linken Abbildung fast vollständig entspannt sind. Die Anschläge 19, 20 an den Führungsstegen 17, 18 begrenzen die vertikale Bewegung des oberen Wärmeleitkörpers 2 relativ zum unteren Wärmeleitkörper 1.

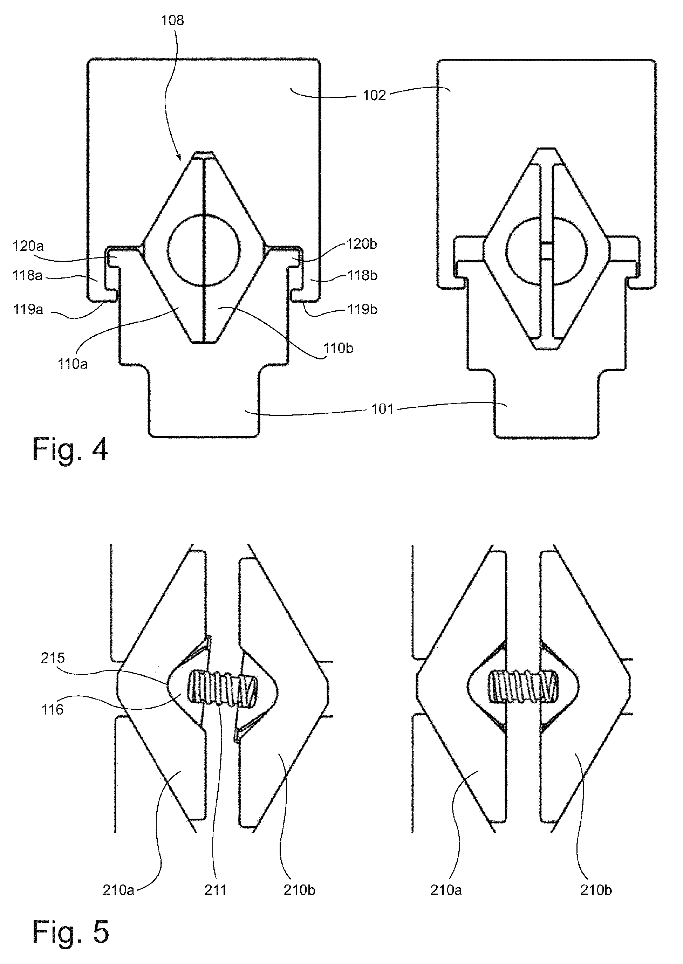

Die zwei Schnittbilder von Figur 4 zeigen eine zweite alternative Ausführungsform des Wärmeübertragers. Auch diese Vorrichtung umfasst einen unteren Wärmeleitkörper 1 und einen oberen Wärmeleitkörper 2, der mit variablem Abstand vertikal über dem ersten Wärmeleitkörper 1 angeordnet ist. Der untere Wärmeleitkörper 1 ist etwas schmaler ausgebildet als der obere Wärmeleitkörper 2. Im Gegensatz zu der ersten Ausführungsform gemäß Figur 1a hat diese Ausführungsform nur ein einziges Spreizelement 108, das zwischen den beiden Wärmeleitkörpern 101, 102 angeordnet ist und zwei horizontal bewegbare Keile 110a, 110b umfasst, deren Keilspitzen in entgegengesetzte Richtungen weisen.

Bei der Ausführungsform gemäß Figur 4 sind nur an dem oberen Wärmeleitkörper 2 rechts und links Führungsstege 118a, 118b angeformt, welche den unteren Wärmeleitkörper 1 seitlich ein Stück umgreifen. Die Führungsstege 118a, 118b haben an ihren freien Enden nach innen gerichtete Abkantungen, welche Anschläge 119a, 119b bilden. Diese wirken mit Gegenanschlägen 120a, 120b am unteren Wärmeleitkörper 101 zusammen.

Das Spreizelement 108 ist im Prinzip gleich ausgebildet wie die zwei Spreizelemente 8, 9 der ersten Ausführungsform des Wärmeübertragers (vgl. Figur 1a, 1b). Insbesondere umfasst das Spreizelement 108 neben den Keilen 110a, 110b eine (hier nicht dargestellte) Feder, welche die Keile 110a, 110b in horizontaler Richtung auseinanderdrückt.

Auch bei der Ausführung gemäß Figur 4 bewirkt die Bewegung der Keile 110a, 110b in horizontaler Richtung eine vertikale Verlagerung des oberen Wärmeleitkörpers 102 gegenüber dem unteren Wärmeleitkörper 101. Während in der linken Abbildung von Figur 4 die beiden Wärmeleitkörper 101, 102 minimalen Abstand haben, haben sie sich in der rechten Abbildung maximal voneinander entfernt.

Die Detailansichten von Figur 5 zeigen eine modifizierte Ausführung der Spreizelemente 8, 9 bzw. 108. Die Keile 210a, 210b haben hier Nuten, die nicht halbkreisförmigen Querschnitt haben, sondern einen Querschnitt in Form eines gleichschenkligen Dreiecks mit verrundeter Spitze aufweisen. Die in den Nuten 215 sitzenden Leisten 216 haben ebenfalls einen Querschnitt in Form eines gleichschenkligen Dreiecks, wobei der von den Schenkeln dieses Dreiecks eingeschlossene Winkel etwas kleiner ist als der entsprechende Winkel der Nuten 215. Bei einer Schrägstellung der Feder 211, wie in der linken Abbildung von Figur 5 dargestellt, können die Leisten 216 um einen entsprechenden Winkel kippen. Dadurch kann ein Höhenversatz zwischen dem linken Keil 210a und dem rechten Keil 210b ausgeglichen werden.

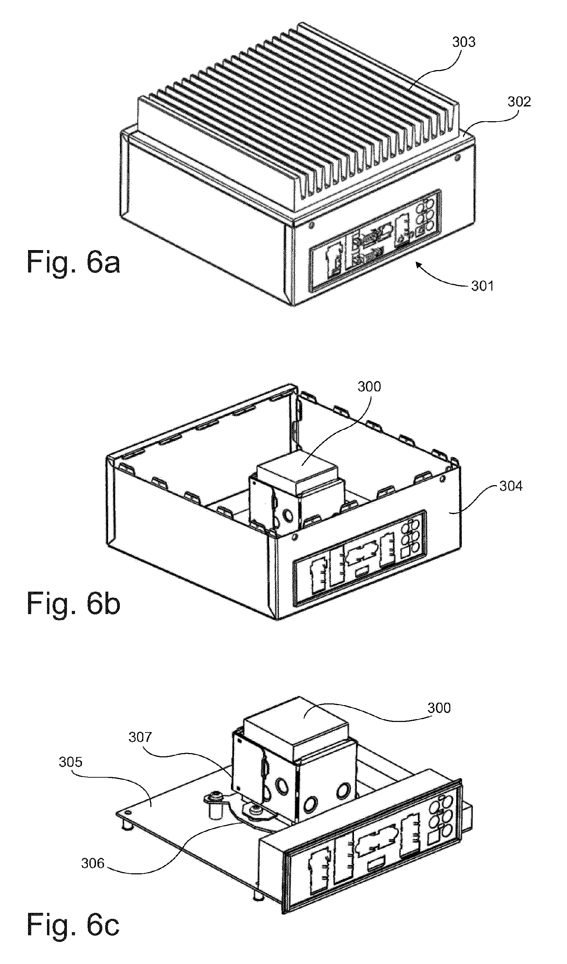

Die Figuren 6a, 6b und 6c erläutern die Verwendung einer Wärmeübertragungsvorrichtung 300 der zuvor beschriebenen Art.

Figur 6a zeigt ein geschlossenes Gehäuse 301 zum Einbau elektronischer Bauelemente, insbesondere eines Mini-ITX Singleboard Computers. Die Oberseite des Deckels 302 des Gehäuses 301 wird fast ganz von einem Kühlkörper 303 eingenommen, der eine Vielzahl von Kühlrippen aufweist und damit eine große Kühlfläche hat.

In Figur 6b ist der Kühlkörper 303 abgenommen, so dass der Blick in das Innere des Gehäuses 301 frei wird. In Figur 6c sind zudem die Seitenwände 304 weggelassen, so dass das Motherboard 305 zu sehen ist. In dessen Mitte sitzt ein Prozessor 306, dessen Verlustwärme abgeführt werden muss. Zu diesem Zwecke ist die Wärmeübertragungsvorrichtung 300 auf die flache Oberseite des Prozessors 306 aufgesetzt. In Figur 6c ist der untere Wärmeleitkörper der Vorrichtung 300 verdeckt durch einen Montageadapter 307. Die Bewegung des oberen Wärmeleitkörpers gegenüber dem unteren Wärmeleitkörper, der fest mit dem Prozessor 306 verbunden ist, wird durch den Montageadapter 307 nicht behindert.

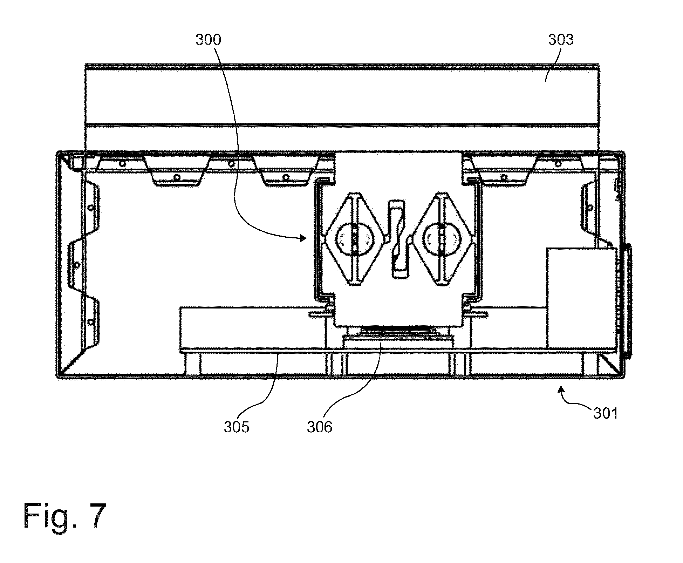

In Figur 7 sind die Federn der Spreizelemente teilweise entspannt, so dass die ebene Oberseite der Wärmeübertragungsvorrichtung 300 federnd gegen die Unterseite des Kühlkörpers 303 gepresst wird. Maßliche Abweichungen sowohl des Prozessors 306 als auch in der Konstruktion des Gehäuses 301 werden somit automatisch ausgeglichen, indem sich die Höhe des Wärmeübertragers 300 automatisch anpasst.

Aus dem Querschnitt von Figur 7 wird deutlich, wie die in das Gehäuse 301 eingesetzte Wärmeübertragungsvorrichtung 300 die vom Prozessor 306 abgegebene Verlustwärme nach oben zum Kühlkörper 303 leitet. Der Wärmefluss wird durch die breiten Pfeile symmetrisch.

### Bezugszeichen

- 1: unterer Wärmeleitkörper
- 2: oberer Wärmeleitkörper
- 3: Abstufung
- 4: Kontaktfläche (von 1)
- 5: Kontaktfläche (von 2)
- 6a, 6b: Gleitflächen (von 1)
- 7a, 7b: Gleitflächen (von 2)
- 8: Spreizelement
- 9: Spreizelement
- 10a, 10b: Keile (von 8)
- 11: Feder (von 8)
- 12a, 12b: Keile (von 9)
- 13: Feder (von 9)
- 14: Keilflächen (von 8, 9)
- 15: Nuten
- 16: Leisten
- 17: Führungssteg (von 1)
- 18: Führungssteg (von 2)
- 19: Anschlag (von 17)
- 20: Anschlag (von 18)

- 101: unterer Wärmeleitkörper
- 102: oberer Wärmeleitkörper
- 108: Spreizelement
- 110a, 110b: Keile (von 108)
- 118a, 118b: Führungsstege
- 119a, 119b: Anschläge
- 120a, 120b: Gegenanschläge

- 210a, 210b: Keile
- 211: Feder
- 215: Nuten
- 216: Leisten

- 300: Wärmeübertragungsvorrichtung
- 301: Gehäuse
- 302: Deckel
- 303: Kühlkörper
- 304: Seitenwände
- 305: Motherboard
- 306: Prozessor
- 307: Montageadapter

## Patentansprüche

1. Vorrichtung zur Übertragung von Wärme, mit
zwei massiven Wärmeleitkörpern (1, 2; 101, 102), die mit variablem Abstand vertikal übereinander angeordnet sind,
einem federelastischen Element, durch das die beiden Wärmeleitkörper (1,2; 101, 102) auseinander gedrückt werden,
**dadurch gekennzeichnet, dass**
zwischen den Wärmeleitkörpern (1, 2; 101, 102) wenigstens ein Spreizelement (8, 9; 108) sitzt, das zwei horizontal bewegbare Keile (10a, 10b, 12a, 12b; 110a, 110b) mit voneinander weg weisenden Keilspitzen umfasst sowie mindestens eine zwischen den Keilen angeordnete Feder (11, 13), welche die Keile auseinander drückt,
die Wärmeleitkörper (1, 2; 101, 102) an ihren zueinander weisenden Seiten jeweils mindestens ein Paar von Gleitflächen (6a, 6b; 7a, 7b) haben, welche parallel zu den Keilflächen (14) verlaufen und auf denen die Keile (10a, 10b, 12a, 12b; 110a, 110b) gleiten, so dass eine Bewegung der Keile in horizontaler Richtung in eine vertikale Bewegung der Wärmeleitkörper umgesetzt wird.

2. Vorrichtung nach Anspruch 1, **dadurch gekennzeichnet, dass** die Keile (10a, 10b, 12a, 12b; 110a, 110b) einen Querschnitt haben, bei dem die Keilflächen (14) auf den Schenkeln eines gleichschenkligen Dreiecks liegen,

3. Vorrichtung nach Anspruch 2, **dadurch gekennzeichnet, dass** die Keilflächen (14) in einem stumpfen Winkel zueinander stehen.

4. Vorrichtung nach einem der vorhergehenden Ansprüche, **dadurch gekennzeichnet, dass** die Paare von Gleitflächen (6a, 6b, 7a, 7b) an den Wärmeleitkörpern (1, 2) jeweils V-förmig angeordnet sind, wobei sich der Winkel zwischen zwei aneinanderstoßenden Gleitflächen (6a, 6b, 7a, 7b) und der Winkel zwischen den zugeordneten Keilflächen (14) zu 180 Grad ergänzen.

5. Vorrichtung nach einem der vorhergehenden Ansprüche, **dadurch gekennzeichnet, dass** die Feder (13) eine Schraubenfeder ist, deren Federachse in einer horizontalen Ebene durch die Keilspitzen liegt.

6. Vorrichtung nach einem der vorhergehenden Ansprüche, **dadurch gekennzeichnet, dass** die Wärmeleitkörper (1, 2; 101, 102) durch eine Führung so miteinander verbunden sind, dass sie im Wesentlichen nur in vertikaler Richtung gegeneinander beweglich sind.

7. Vorrichtung nach Anspruch 6, **dadurch gekennzeichnet, dass** die Führung einen Anschlag (19, 20; 119a, 119b) hat, der die maximale Verschiebung begrenzt.

8. Vorrichtung nach einem der vorhergehenden Ansprüche, **dadurch gekennzeichnet, dass**
zwei Spreizelemente (8, 9) horizontal nebeneinander angeordnet sind,
die beiden Wärmeleitkörper (1, 2) jeweils zwei Paare von V-förmig angeordneten Gleitflächen (6a, 6b, 7a, 7b) haben.

9. Vorrichtung nach einem der vorhergehenden Ansprüche, **dadurch gekennzeichnet, dass** die Wärmeleitkörper (1, 2; 101, 102) einstückig als Strangpressprofil hergestellt sind.

10. Vorrichtung nach Anspruch 9, **dadurch gekennzeichnet, dass** beide Wärmeleitkörper (1, 2) aus dem gleichen Strangpressprofil hergestellt sind.
